# EUROPEAN PATENT SPECIFICATION

(11) **EP 3 043 382 B1**
(45) Date of publication and mention of the grant of the patent: **02.08.2017**
(21) Application number: 15200529.4
(22) Date of filing: 16.12.2015
(51) Int. Cl.: H05K 1/14, H05K 1/02, H01Q 21/06, H01L 23/66, H05K 1/18, H05K 3/36, H01P 5/02

(54) **CIRCUIT BOARD ASSEMBLY WITH HIGH AND LOW FREQUENCY SUBSTRATES**
LEITERPLATTENANORDNUNG MIT HOCH- UND NIEDERFREQUENTEN SUBSTRATEN
ENSEMBLE CARTE À CIRCUIT IMPRIMÉ AVEC DES SUBSTRATS DE HAUTE ET DE BASSE FRÉQUENCE

(30) Priority: 07.01.2015 US 201514591120
(43) Date of publication of application: 13.07.2016
(73) Proprietor: Delphi Technologies, Inc., Troy, MI 48007 (US)
(72) Inventor: ZIMMERMAN, David W., Fishers, INDIANA 46038 (US); SEARCY, James F., Westfield, INDIANA 46074 (US); DELHEIMER, Charles I., Noblesville, INDIANA 46060 (US)
(74) Representative: Delphi France SAS

(56) References cited:
- EP-A1- 1 480 264
- EP-A1- 1 515 389
- EP-A2- 1 094 541
- EP-A2- 1 307 078
- US-A1- 2014 063 754

## Description

### TECHNICAL FIELD

This disclosure generally relates to a circuit board assembly, and more particularly relates to a cost efficient interconnection of substrates, electrical devices, and an antenna for transmitting and/or receiving a radio-frequency signal.

### BACKGROUND OF INVENTION

It is known to include a Monolithic Microwave Integrated Circuit (MMIC) in a circuit board assembly of a cost sensitive millimeter-wavelength product such as an automotive radar system. Standard packages such as a Quad Flat No-leads (QFN) package are not preferred for mm-wave devices as such packages do not provide suitable performance for quality RF interfaces. High-frequency substrates are generally more expensive than low-frequency (e.g. FR-4) substrates, so building an entire circuit board assembly using only a high-frequency substrate undesirably increases cost. However, a packaging solution for a MMIC requires efficient transfer of radio-frequency (RF) signals via a suitable substrate interface; as well as necessary low frequency signals for power, control signals, and baseband interfaces.

Relevant background art is disclosed in EP 1 307 078, EP 1 094 541, EP 1 515 389, US 2014/063754 and EP 1 480 264.

### SUMMARY OF THE INVENTION

In accordance with one embodiment, a circuit board assembly is provided. The circuit board assembly includes a low-frequency (LF) substrate, a monolithic microwave integrated circuit (MMIC), a plurality of electrical components, a high-frequency (HF) substrate, a plurality of wire bonds, and an antenna. The LF substrate is formed of FR-4 type material. The LF substrate defines a top-side, a bottom-side, and a waveguide through the LF substrate configured to guide a radio-frequency signal from the top-side to the bottom-side. The MMIC is attached to the top-side and configured to output the radio-frequency signal. The plurality of electrical components are electrically attached to the LF substrate and configured to process a low-frequency signal. The HF substrate is attached to the top-side. The HF substrate is configured to define a solder pad configured to couple the low-frequency signal from the LF substrate to the HF substrate. The HF substrate is also configured to an opening through the HF substrate configured to surround the MMIC. The HF substrate is also configured to a vertical transition configured to guide the radio-frequency signal output by the MMIC to the waveguide. The plurality of wire bonds electrically connects the MMIC to the HF substrate and couple the radio-frequency signal from the MMIC to the vertical transition. The antenna is attached to the LF substrate and configured to radiate the radio-frequency signal from the waveguide.

Further features and advantages will appear more clearly on a reading of the following detailed description of the preferred embodiment, which is given by way of non-limiting example only and with reference to the accompanying drawings.

### BRIEF DESCRIPTION OF DRAWINGS

The present invention will now be described, by way of example with reference to the accompanying drawings, in which:
Fig. 1 is an isometric view of a circuit board assembly in accordance with one embodiment; and
Figs. 2A, 2B, and 2C are exploded views of the assembly of Fig. 1 from different perspectives in accordance with one embodiment.

### DETAILED DESCRIPTION OF THE INVENTION

Described herein is a circuit board assembly that provides an economical assembly for electrical systems that have or process both relatively low-frequency signals with frequency spectrums less than 100MHz, including DC power, and relatively high frequency signals, i.e. radio-frequency signals with frequency spectrums greater than 1GHz. By way of example and not limitation, the circuit board assembly described herein would be well suited for an automotive radar system operating with a radar signal frequency of 76.5GHz. While the description presented herein is generally directed to the transmission of a radio-frequency signal, it is recognized that the teachings are applicable to circuit board assemblies that only receive a radio-frequency signal, and both transmit and receive a radio-frequency signal as would be the case for a radar system.

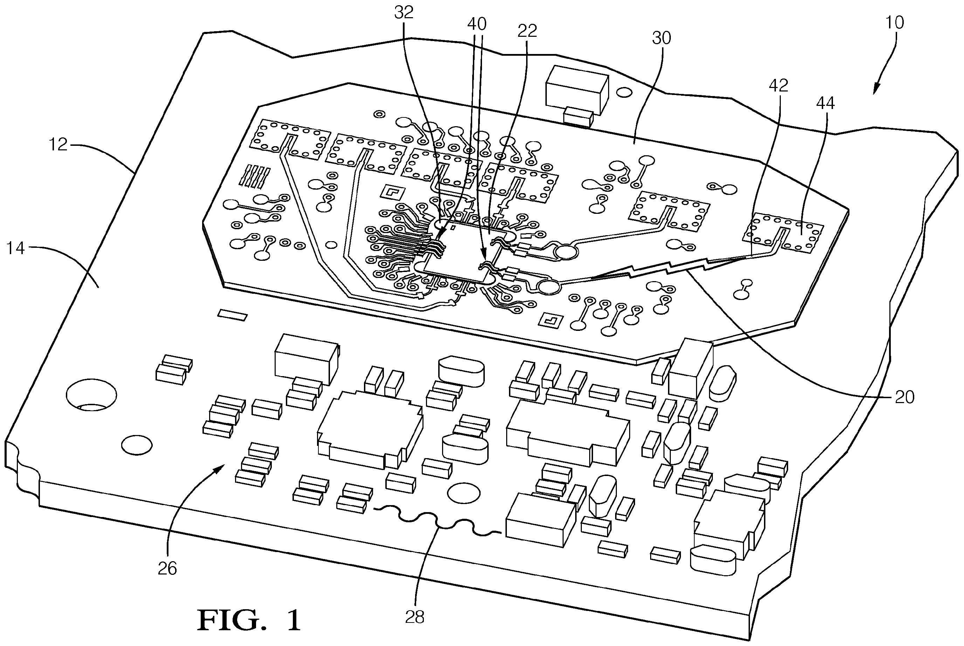

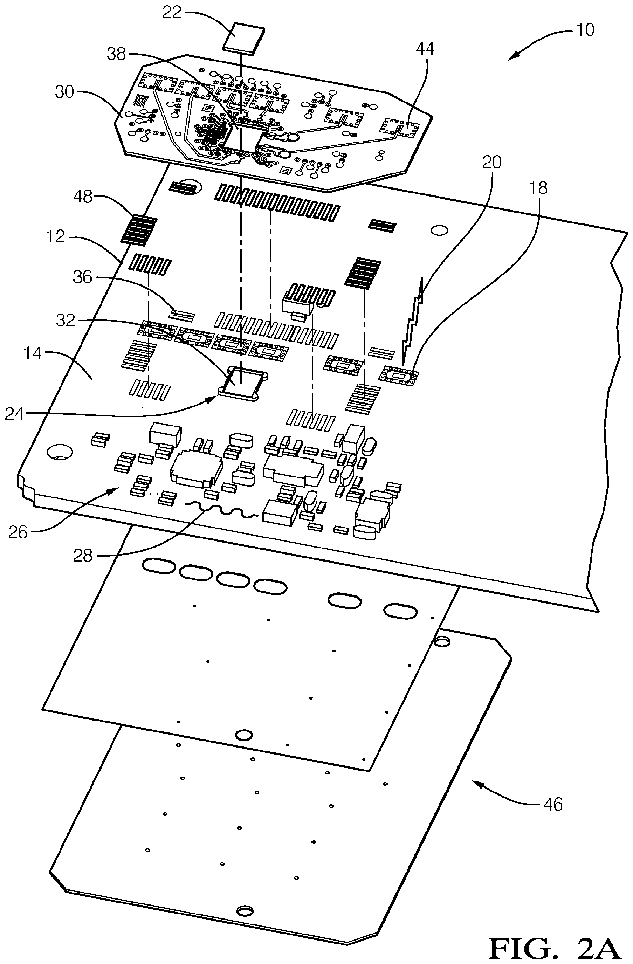

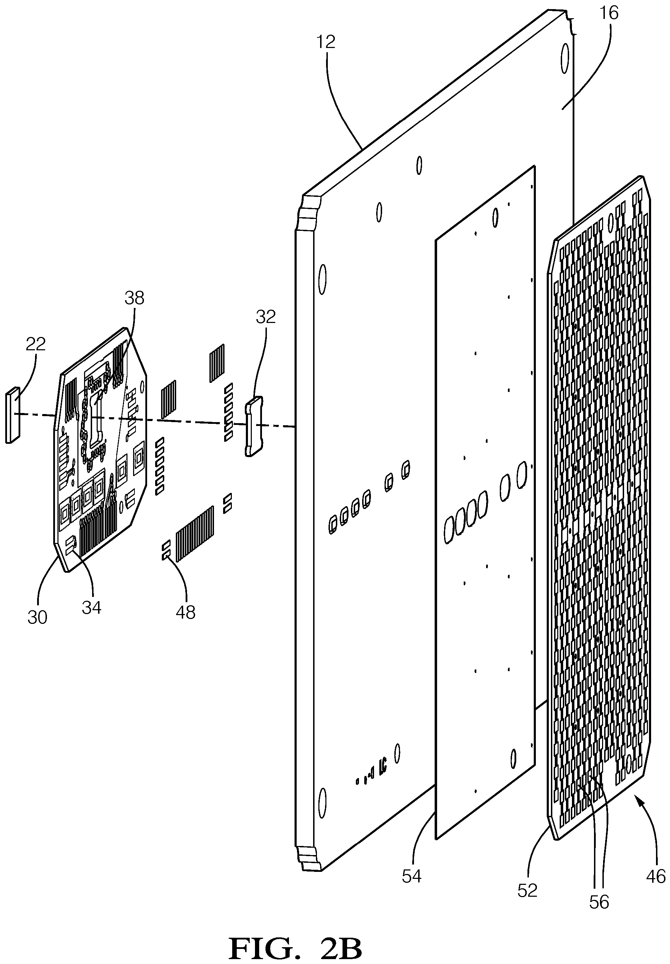

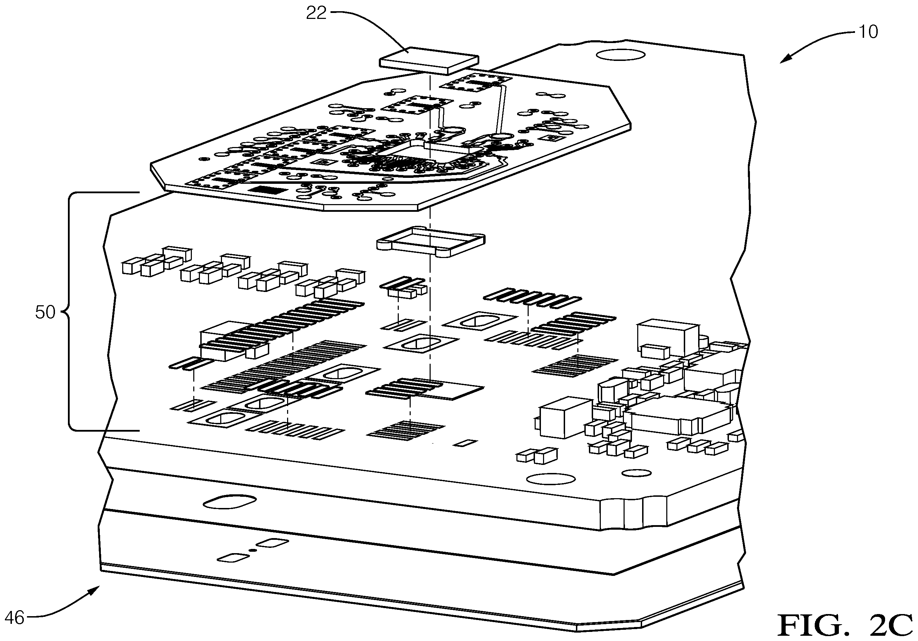

Figs. 1, 2A, 2B, and 2C cooperatively illustrate a non-limiting example of a circuit board assembly, hereafter referred to as the assembly 10. The assembly 10 is generally built upon or around a low-frequency substrate, hereafter the LF substrate 12. The LF substrate 12 is advantageously formed of FR-4 type material as it is relatively low in cost and readily available. The LF substrate defines a top-side 14, a bottom-side 16, and a waveguide 18 through the LF substrate 12 configured to guide a radio-frequency signal 20 (Fig. 2A) from the top-side 14 to the bottom-side 16. The waveguide 18 may be plated in a manner similar to a plated through-hole in order to better conduct or propagate the radio-frequency signal 20 through the LF substrate.

The assembly 10 includes a monolithic microwave integrated circuit, hereafter the MMIC 22, attached to the top-side 14 and configured to output the radio-frequency signal 20. Additional features described below conduct or propagate the radio-frequency signal 20 from the MMIC 22 to the waveguide 18. If the MMIC produces an excessive amount of heat, the LF substrate 12 may be configured to include a heat sink 24 proximate to (e.g. underneath) the MMIC 22 to better dissipate heat emitted by the MMIC 22. The heat sink 24 may include an one or more vias or plated through-holes in the LF substrate 12, and/or one or layers of conductor such as copper foil that cooperate to spread and/or conduct heat away from the MMIC 22. The MMIC 22 may be attached to the LF substrate 12 by solder or an adhesive 32. If the heat sink 24 is needed, the adhesive 32 may be, for example, a thermally conductive epoxy.

The assembly 10 includes a plurality of electrical components 26 electrically attached to the LF substrate 12. In general, the electrical components 26 are configured to route, conduct, and/or process a low-frequency signal 28. The electrical components may include a capacitor, a resistor, or a processor such as a microprocessor. As suggested above, the low-frequency signal 28 is generally less than 100MHz because the FR-4 material used to form the LF substrate 12 is not well suited to higher frequency signals such as the radio-frequency signal 20.

In order to route the radio-frequency signal 20 from the MMIC 22 to the waveguide 18, the assembly 10 includes a high-frequency substrate, hereafter the HF substrate 30 attached to the top-side 14 of the LF substrate 12. A suitable material for the HF substrate 30 is 0.5mm thick RO5880 manufactured by Rogers Corp. The HF substrate 30 is configured to define a solder pad 34 (Fig. 2B) used to couple the low-frequency signal 28 from a corresponding solder pad 36 (Fig. 2A) on the LF substrate 12 to the HF substrate 30. In this way, the MMIC 22 can be supplied with DC power and control signals from the lower cost FR-4 substrate, i.e. the LF substrate 12.

The HF substrate 30 may include or define an opening 38 through the HF substrate 30 that surrounds the MMIC 22. A plurality of wire bonds 40 can then be used to electrically connect the MMIC 22 to the HF substrate 30 and thereby couple the radio-frequency signal 20 from the MMIC 22 to a microstrip 42 on the HF substrate 30. By placing the MMIC 22 into the opening 38, the length of the wire bonds 40 can be minimized which is advantageous for high frequency signals such as the radio-frequency signal 20. Preferably, the thicknesses of the various parts that make up the assembly 10 are such that wire bond pads on the MMIC 22 are co-planar, or as close to co-planar as feasible, with wire bond pads on the HF substrate 30 so the length of the wire bonds 40 is minimized.

The HF substrate 30 may include or define a vertical transition 44 configured to guide the radio-frequency signal 20 output by the MMIC 22 to the waveguide 18. As will be recognized by those in the art, the vertical transition 44 redirects the radio-frequency signal 20 propagating horizontally across the surface of the HF substrate 30 to propagate in a vertical direction through the waveguide 18 and to an antenna 46 attached to the bottom side 16 of the LF substrate 12. In general, the antenna 46 is configured to radiate the radio-frequency signal 20 from the waveguide 18. While the explanation thus far has been directed to the radio-frequency signal 20 being output by the MMIC 22 and radiated by the antenna 46, it is contemplated that signals may be received by the antenna 46 and detected by the MMIC, as would be the case for a radar system using the assembly 10 described herein.

The solder pad 34 of the HF substrate 30, the solder pad 36 of the LF substrate 12, and solder material 48 cooperate to form a solder joint 50 to attached the HF substrate 30 to the LF substrate 12 and thereby provide a means to couple the low-frequency signal 28 between the HF substrate 30 to the LF substrate 12. Preferably, the solder joint 50 has a thickness selected to optimize coupling of the radio-frequency signal 20 between the vertical transition 44 and the waveguide 18, but still provide adequate strength. In general, the thinner the solder joint 50, the better the coupling of the radio-frequency signal 20. However, if the solder joint 50 is too thin, the solder joint may have poor reliability. By way of example and not limitation, a suitable thickness of the solder material 48 after reflow is fifty micrometers (50um).

The antenna 46 may include a support substrate 52 attached to the bottom-side 16 by an adhesive 54. If the operating frequency of the antenna 46 is 76.5 GHz, the support substrate 52 may be a 0.38 millimeter (mm) thick PTFE substrate. Elements 56 of the antenna 46 may have a patch size of 1.07mm square and a patch pitch of 2.98mm. A suitable material for the adhesive 54 is a silicone based adhesive with a suitable thickness of fifty micrometers (50um).

Accordingly, a circuit board assembly (the assembly 10) suitable for applications such as an automotive radar system is provided. The assembly 10 uses a small RF substrate (the HF substrate 30) suitable for surface mount attachment to the LF substrate 12. The low frequency signal 28 interconnects through attachment of the substrates by the solder joint 50. Enhanced RF performance of the transition from the HF substrate 30 to the LF substrate is provided by a low profile solder connect that is relatively low when compared to typical BGA package techniques. The assembly 10 enables MMIC packaging with low and high frequency interconnects to generic FR4 substrate which is generally not suitable for efficient high frequency microstrip/stripline routing. The assembly 10 described herein is particularly useful as commercial products are increasingly using Monolithic Microwave Integrated Circuits (MMICs) to support mm-wave products that require both low and high frequency RF interfaces. Standard packages (e.g. QFN) are generally not effective for mm-wave devices as they do not provide suitable performance for quality RF interfaces. A packaging solution for a MMIC requires the ability to efficiently transfer RF signals via a suitable substrate interface; as well as necessary low frequency signals for power, control, and baseband interfaces. However, suitable high-frequency substrate materials are typically significantly more expensive than standard (i.e. low-frequency) substrate materials, resulting in a strong commercial incentive to minimize the area of use.

While this invention has been described in terms of the preferred embodiments thereof, it is not intended to be so limited, but rather only to the extent set forth in the claims that follow.

## Claims

1. A circuit board assembly (10) comprising:
a low-frequency (LF) substrate formed of FR-4 type material, wherein the If substrate (12) defines a top-side (14), a bottom-side (16), and a waveguide (18) through the If substrate (12) configured to guide a radio-frequency signal (20) from the top-side (14) to the bottom-side (16);
a monolithic microwave integrated circuit (MMIC (22)) attached to the top-side (14) and configured to output the radio-frequency signal (20);
a plurality of electrical components (26) electrically attached to the If substrate (12) and configured to process a low-frequency signal (28);
a high-frequency (HF) substrate attached to the top-side (14), wherein the HF substrate (30) is configured to define a solder pad (34) configured to couple the low-frequency signal (28) from the If substrate (12) to the HF substrate (30), an opening (38) through the HF substrate (30) configured to surround the MMIC (22), and a vertical transition (44) configured to guide the radio-frequency signal (20) output by the MMIC (22) to the waveguide (18);
a plurality of wire bonds (40) to electrically connect the MMIC (22) to the HF substrate (30) and couple the radio-frequency signal (20) from the MMIC (22) to the vertical transition (44); and
an antenna (46) attached to the If substrate (12) and configured to radiate the radio-frequency signal (20) from the waveguide (18).

2. The assembly (10) in accordance with claim 1, wherein wire bond pads on the MMIC (22) are co-planar with wire bond pads on the HF substrate (30).

3. The assembly (10) in accordance with claim 1, wherein the solder pad (34) of the HF substrate (30) is part of a solder joint (50) that attaches the HF substrate (30) to the If substrate (12), and couples the low-frequency signal (28) therebetween.

4. The assembly (10) in accordance with claim 3, wherein the solder joint (50) has a thickness selected to optimize coupling of the radio frequency signal between the vertical transition (44) and the waveguide (18).

5. The assembly (10) in accordance with claim 1, wherein the If substrate (12) includes a heat sink (24) proximate to the MMIC (22) configured to dissipate heat emitted by the MMIC (22).

6. The assembly (10) in accordance with claim 1, wherein the antenna (46) includes a support substrate (52) attached to the bottom-side (16) by an adhesive (32).

## Patentansprüche

1. Leiterplattenanordnung (10), die aufweist:
ein Niederfrequenz(LF - low-frequency)-Substrat, das aus einem FR-4-Typ-Material gebildet ist, wobei das lf-Substrat (12) eine Oberseite (14), eine Unterseite (16) und einen Wellenleiter (18) durch das lf-Substrat (12) definiert, konfiguriert zum Leiten eines Funkfrequenzsignals (20) von der Oberseite (14) zu der Unterseite (16);
eine monolithische integrierte Mikrowellenschaltung (MMIC - monolithic microwave integrated circuit (22)), die an der Oberseite (14) angebracht ist und konfiguriert ist zum Ausgeben des Funkfrequenzsignals (20);
eine Vielzahl von elektrischen Komponenten (26), die mit dem lf-Substrat (12) elektrisch verbunden sind und konfiguriert sind zum Verarbeiten eines Niederfrequenzsignals (28);
ein Hochfrequenz(HF - high-frequency)-Substrat, das an der Oberseite (14) angebracht ist, wobei das HF-Substrat (30) konfiguriert ist zum Definieren eines Lötpads (34), das konfiguriert ist zum Koppeln des Niederfrequenzsignals (28) von dem Substrat (12) mit dem HF-Substrat (30), wobei eine Öffnung (38) durch das HF-Substrat (30) konfiguriert ist, die MMIC (22) zu umgeben, und einen vertikalen Übergang (44), der konfiguriert ist zum Leiten des Funkfrequenzsignals (20), das von der MMIC (22) ausgegeben wird, an den Wellenleiter (18);
eine Vielzahl von Draht-Bonds (40), um die MMIC (22) mit dem HF-Substrat (30) elektrisch zu verbinden und das Funkfrequenzsignal (20) von der MMIC (22) mit dem vertikalen Übergang (44) zu koppeln; und
eine Antenne (46), die an dem lf-Substrat (12) angebracht ist und konfiguriert ist zum Ausstrahlen des Funkfrequenzsignals (20) von dem Wellenleiter (18).

2. Die Anordnung (10) gemäß Anspruch 1, wobei Draht-Bond-Pads auf der MMIC (22) koplanar mit Draht-Bond-Pads auf dem HF-Substrat (30) sind.

3. Die Anordnung (10) gemäß Anspruch 1, wobei das Lötpad (34) des HF-Substrats (30) Teil einer Lötverbindung (50) ist, die das HF-Substrat (30) mit dem lf-Substrat (12) verbindet und das Niederfrequenzsignal (28) dazwischen koppelt.

4. Die Anordnung (10) gemäß Anspruch 3, wobei die Lötverbindung (50) eine Dicke hat, die ausgewählt ist, um eine Kopplung des Funkfrequenzsignals zwischen dem vertikalen Übergang (44) und dem Wellenleiter (18) zu optimieren.

5. Die Anordnung (10) gemäß Anspruch 1, wobei das lf-Substrat (12) eine Wärmesenke (24) nahe der MMIC (22) aufweist, die konfiguriert ist zum Ableiten von Wärme, die von der MMIC (22) emittiert wird.

6. Die Anordnung (10) gemäß Anspruch 1, wobei die Antenne (46) ein Trägersubstrat (52) aufweist, das durch einen Klebstoff (32) an der Unterseite (16) angebracht ist.

## Revendications

1. Assemblage de cartes à circuits (10) comprenant :
un substrat à basse fréquence (LF) formé d'un matériau du type FR-4, dans lequel le substrat If définit un côté supérieur (14), un côté inférieur (16), et un guide d'onde (18) à travers le substrat If (12) configuré pour guider un signal à radiofréquences (20) depuis le côté supérieur (14) vers le côté inférieur (16) ;
un circuit intégré à micro-ondes monolithique (MMIC) (22) attaché sur le côté supérieur (14) et configuré pour délivrer le signal à radiofréquences (20) ;
une pluralité de composants électriques (26) électriquement attachés au substrat If (12) et configurés pour traiter un signal à basse fréquence (28) ;
un substrat à haute fréquence (HF) attaché sur le côté supérieur (14), dans lequel le substrat HF (30) est configuré pour définir un patin de soudure (34) configuré pour coupler le signal à basse fréquence (28) depuis le substrat If (12) vers le substrat HF (30), une ouverture (38) à travers le substrat HF (30), configurée pour entourer le MMIC (22), et une transition verticale (44) configurée pour guider le signal à radiofréquences (20) délivré par le MMIC (22) vers le guide d'onde (18), une pluralité de jonctions filaires (40) pour connecter électriquement le MMIC (22) vers le substrat HF (30) et coupler le signal à radiofréquences (20) depuis le MMIC (22) vers la transition verticale (44) ; et
une antenne (46) attachée au substrat If (12) et configurée pour rayonner le signal à radiofréquences (20) depuis le guide d'onde (18).

2. Assemblage (10) selon la revendication 1, dans lequel des patins de jonctions filaires sur le MMIC (22) sont coplanaires avec des patins de jonctions filaires sur le substrat HF (30).

3. Assemblage (10) selon la revendication 1, dans lequel le patin de soudure (34) du substrat HF (30) fait partie d'un joint de soudure (50) qui attache le substrat HF (30) au substrat If (12) et qui couple le signal à basse fréquence (28) entre ceux-ci.

4. Assemblage (10) selon la revendication 3, dans lequel le joint de soudure (50) a une épaisseur sélectionnée pour optimiser le couplage du signal à radiofréquences entre la transition verticale (44) et le guide d'onde (18).

5. Assemblage (10) selon la revendication 1, dans lequel le substrat If (12) inclut un puits de chaleur (24) à proximité du MMIC (22) et configuré pour dissiper la chaleur émise par le MMIC (22).

6. Assemblage (10) selon la revendication 1, dans lequel l'antenne (46) inclut un substrat support (52) attaché sur le côté inférieur (16) par un adhésif (32).
